Europäisches Patentamt

European Patent Office

Office européen des brevets

(11) Veröffentlichungsnummer: **0 256 287 B1**

(12) **EUROPÄISCHE PATENTSCHRIFT**

(45) Veröffentlichungstag der Patentschrift: 02.05.91

(21) Anmeldenummer: 87109772.1

(22) Anmeldetag: 07.07.87

(51) Int. Cl.5: **H03D 1/22**, G08G 1/09, H04L 27/06

(54) Demodulator zur Demodulation von Eingangsssignalen.

(30) Priorität: 09.08.86 DE 3627007

(43) Veröffentlichungstag der Anmeldung:
24.02.88 Patentblatt 88/08

(45) Bekanntmachung des Hinweises auf die
Patenterteilung:
02.05.91 Patentblatt 91/18

(84) Benannte Vertragsstaaten:
AT CH ES FR GB IT LI SE

(56) Entgegenhaltungen:
DE-A- 3 433 592

EBU REVIEW-TECHNICAL, Nr. 204, April 1984,
Seiten 50-58, Brüssel, BE; S.R. ELY et al.:
"Design principles for VHF/FM radio receivers using the EBU radio-data system RDS"

IEEE TRANSACTIONS ON COMMUNICA-
TIONS, Band COM-25, Nr. 2, Februar 1977,
Seiten 215-227; M.K. SIMON et al.: "Optimum
performance of suppressed carrier receivers with Costas loop tracking"

(73) Patentinhaber: Blaupunkt-Werke GmbH
Robert-Bosch-Strasse 200
W-3200 Hildesheim(DE)

(72) Erfinder: Hegeler, Wilhelm
Grosse Venedig 23
W-3200 Hildesheim(DE)
Erfinder: Poschen, Dieter
Sedanstrasse 32
W-3200 Hildesheim(DE)

(74) Vertreter: Eilers, Norbert, Dipl.-Phys.
Blaupunkt-Werke GmbH Robert-
Bosch-Strasse 200
W-3200 Hildesheim(DE)

**Beschreibung**

Die Erfindung betrifft einen digitalen Demodulator gemäß dem Oberbegriff des Anspruchs 1. Demodulatoren dieser Art werden vor allem in Autoradios benötigt, die sowohl Verkehrsfunkkennungen (ARI-Signale) als auch Informationen des Radiodatensystems (RDS-Signale) auswerten sollen.

Es ist schon bekannt, dem Autofahrer zur Verbesserung des Verkehrsablaufes und zur Erhöhung der Verkehrssicherheit über bestimmte Rundfunksender (Verkehrsfunksender) Verkehrshinweise zu geben. Um dabei dem Autofahrer das Aufsuchen des für seinen örtlichen Bereich zuständigen Verkehrsfunksenders zu erleichtern, wird in üblicher Weise das bekannte sogenannte Kennungssystem ARI (eingetragenes Warenzeichen) eingesetzt, welches drei Kennfrequenzen verwendet, die im UKW-Bereich zusätzlich zur Nutzmodulation des FM-Verkehrsfunksenders aufmoduliert werden. Für die Senderkennung ist dabei ein 57 kHz-Träger vorgesehen, der zur Kennzeichnung aller Verkehrsfunksender dient.

Neben dem Kennungssystem ARI ist zusätzlich auch noch das sogenannte RDS-System bekannt geworden ("Specification of the radio data system RDS", Sonderdruck der EBU Technical centre, Brüssel, Tech. 3244 E, März 1984), welches die Übertragung von Informationen ermöglicht, die beispielsweise die Art des jeweiligen gesendeten und empfangenen Programmes (Programmtyp), eine Senderidentifikation, alternative Sendefrequenzen usw. betreffen.

Bei dem RDS-System erfolgt die Übertragung der RDS-Informationen in Form von digitalen Signalen auf einem Unterträger von 57 kHz über UKW-Rundfunksender, wobei eine Zweiseitenbandamplitudenmodulation des 57 kHz-Trägers (Träger wird unterdrückt) mit dem biphase-codierten Datensignal erfolgt. Durch die Biphase-Codierung erscheinen in der Nähe des Trägers keine Spektrallinien, so daß eine Kompatibilität mit dem ARI-System gegeben ist.

Somit besteht also grundsätzlich in vorteilhafter Weise die Möglichkeit, sowohl ARI-Signale und/oder RDS-Signale zu übertragen, und empfängerseitig stellt sich dann die Forderung nach einem Demodulator, der die Rückgewinnung der gesendeten aufmodulierten ARI-Signale und RDS-Signale gewährleistet. Zu diesem Zweck wird ein digitaler Demodulator gemäß dem Oberbegriff des Anspruchs 1 benötigt und verwendet.

Beim Einsatz eines digitalen Demodulators nach dem PLL-Prinzip läßt sich die obige Forderung in der Praxis aber nicht erfüllen. Der PLL-Demodulator kann nämlich nur für den Fall ARI = 1 einrasten, wenn also der 57 kHZ-Träger vorhanden ist. Im Falle ARI = 0, wenn kein Träger vorhanden ist, läßt sich ein RDS-Signal nicht demodulieren. Dies bedeutet, das mit einem PLL-Demodulator RDS-Signale nur dann gewonnen werden können, wenn der 57 kHz-Träger vorhanden ist (ARI = 1).

Mit einem weiter unten anhand der Zeichnung noch näher beschriebenen Demodulator nach dem sogenannten "Costas-Loop-Prinzip" ist es demgegenüber zwar grundsätzlich möglich, auch im Falle ARI = 0 ein RDS-Signal zu demodulieren und zu erhalten, allerdings besteht dabei der Nachteil, daß das RDS-Signal - in Abhängigkeit der Möglichkeiten ARI = 0 oder ARI = 1 - an unterschiedlichen Ausgangsklemmen abgegriffen werden muß.

An einer ersten Ausgangsklemme erscheint das RDS-Signal für den Fall ARI = 0, während an dieser Klemme für den Fall ARI = 1 das ARI-Signal abgegriffen werden kann. An einer zweiten Ausgangsklemme steht das RDS-Signal nur dann zur Verfügung, wenn der 57 kHz-Träger vorhanden ist (ARI = 1).

Da die RDS-Signale in Abhängigkeit von dem Vorhandensein des 57 kHz-Trägers an unterschiedlichen Ausgangsklemmen auftreten, läßt sich diese Costas-Loop-Schaltung in der Praxis nicht einsetzen. Es wäre nämlich ein erheblicher zusätzlicher elektronischer Schaltungsaufwand erforderlich, um unabhängig für die Fälle ARI = 0 und ARI = 1 zu gewährleisten, daß das RDS-Signal immer an einer gleichen Ausgangsklemme zur Verfügung steht.

In der eigenen älteren Patentanmeldung EP-A-025 4061, die am 27-1-88 veröffentlicht worden ist, ist auch schon der Vorschlag gemacht, eine PLL-Schaltgtung mit einer Costas-Loop-Schaltung in einer solchen Weise zu kombinieren, daß der Demodulator sowohl im Falle ARI = 0 und ARI = 1 stabil einrasten kann, so daß in beiden Fällen das RDS-Signal jeweils an ein und derselben Ausgangsklemme ansteht. Dabei wird der Costas-Loop-Schaltung eine Steuergröße der normalen PLL-Schaltung überlagert, so daß im Falle ARI = 1 ein Dominieren der PLL-Funktion auftritt.

Mit einem Demodulator gemäß diesem Vorschlag läßt sich zwar das angestrebte Ziel grundsätzlich verwirklichen, allerdings kann sich dabei der Nachteil einer Erhöhung des Rauschens innerhalb der Phasenregelschleife einstellen.

Der Erfindung liegt die Aufgabe zugrunde, mit einfachen Schaltungsmaßnahmen einen Demodulator für die ARI- und RDS-Demodulation zu schaffen, bei welchem das RDS-Signal unabhängig von der Anwesenheit eines ARI-Trägers an einem ganz bestimmten Ausgang entsteht und zur Weiterverarbeitung abgenommen werden kann.

Die Lösung dieser Aufgabe erfolgt bei dem im Oberbegriff des Anspruchs 1 genannten Demodulator durch die im kenn zeichnenden Teil des Anspruchs 1 angegebenen Merkmale.

Der Erfindung liegt der Gedanke zugrunde, mittels einer schnellen ARI-Erkennungsschaltung die Steuergröße einer Costas-Loop zwischen dem Costas-Mischer und einem gegebenenfalls nachgeschalteten Tiefpaß zu invertieren, also eine 90°-Drehung des stabilen Zustandes herbeizuführen. Dann liegt praktisch eine Costas-Loop-Schaltung vor, bei der das RDS-Signal in gewünschter Weise immer an der gleichen Ausgangsklemme zur Verfügung steht, d.h. der Demodulator ist sowohl im Falle ARI = 0 als auch im Falle ARI = 1 stabil eingerastet, und in beiden Fällen entsteht das RDS-Signal an einer bestimmten gleichen Ausgangsklemme.

Für die ARI-Erkennung kann in zweckmäßiger Weise die Information dienen, daß innerhalb der letzten RDS-Periode eine der beiden in Sinus- und Cosinuskomponente aufgeteilten Ausgangssignale der Tiefpässe frei von Vorzeichenwechseln gewesen ist (dann gilt nämlich ARI = 1).

In vorteilhafter Weise können die Sinus- und Cosinuskomponenten auch als binäre Größen vorliegen. Dann genügt eine einfache Flankenerkennung.

In einer zweckmäßigen Ausgestaltung der Erfindung wird das - gegebenenfalls invertierte - Steuersignal dem spannungsgesteuerten Oszillator über einen Tiefpaß zugeführt. Durch diesen Tiefpaß werden eventuelle kurzzeitige Fehler der ARI-Erkennung "ignoriert", d.h. die Phasensteuerung reagiert auf den Mittelwert des ARI-Pegels. Kurzzeitige Fehlerkennungen könnten höchstens einen schwachen Phasenjitter (ein "Zappeln" der Phase ) verursachen.

Bei der Erfindung kann die Loop bei A = 0 und ARI = 0 so eingestellt werden, daß das RDS-Signal an der Schaltungsstelle erscheint, an der die Sinuskomponente am Mischerausgang vorhanden ist. Die Costas-Loop rastet dann immer so ein, daß die Signalextremwerte an der genannten Schaltungsstelle und die Signal-Nulldurchgänge an der anderen Schaltungsstelle erscheinen, an der am Mischerausgang die Cosinuskomponente auftritt.

Bei ARI = 1 (und A = 0!) würde das ARI-Signal normalerweise an der Schaltungsstelle mit der Sinuskomponente erscheinen, weil die Loop dann auf das stärkere ARI-Signal einrasten würde, und das RDS-Signal würde an der anderen Schaltungsstelle, wo am Mischerausgang die Cosinuskomponente auftritt, erscheinen. Durch die ARI-Erkennung - wenn also A = 1 gilt - und durch die gemäß der Erfindung damit verbundene Invertierung der Costas-Loop-Steuergröße für den spannungsgesteuerten Oszillator wird jedoch eine 90°-Drehung des stabilen Zustandes herbeigeführt, wodurch das RDS-Signal immer an der gleichen Schaltungsstelle erscheint, sobald eine ARI-Erkennung stattgefunden hat und ARI richtig erkannt worden ist.

Zweckmäßige Ausgestaltungen und vorteilhafte Weiterbildungen der Erfindung sind in den Unteransprüchen angegeben und der Zeichnung zu entnehmen.

Nachfolgend wird die Erfindung zum besseren Verständnis anhand des in der Zeichnung dargestellten Ausführungsbeispiels näher erläutert. Es zeigen:

Fig. 1 ein Blockschaltbild eines Demodulators in PLL-Schaltung,

Fig. 2 ein Blockschaltbild eines Demodulators in Costas-Loop-Schaltung,

Fig. 3 ein Prinzip-Schaltbild eines Ausführungsbeispiels eines Demodulators gemäß der Erfindung mit einer ARI-Erkennungsschaltung,

Fig. 4 ein schematisches Schaltbild einer ARI-Erkennungsschaltung nach Fig. 3, und

Fig. 5 ein Prinzip-Schaltbild eines erfindungsgemäßen Demodulators für die Verarbeitung binärer Signale.

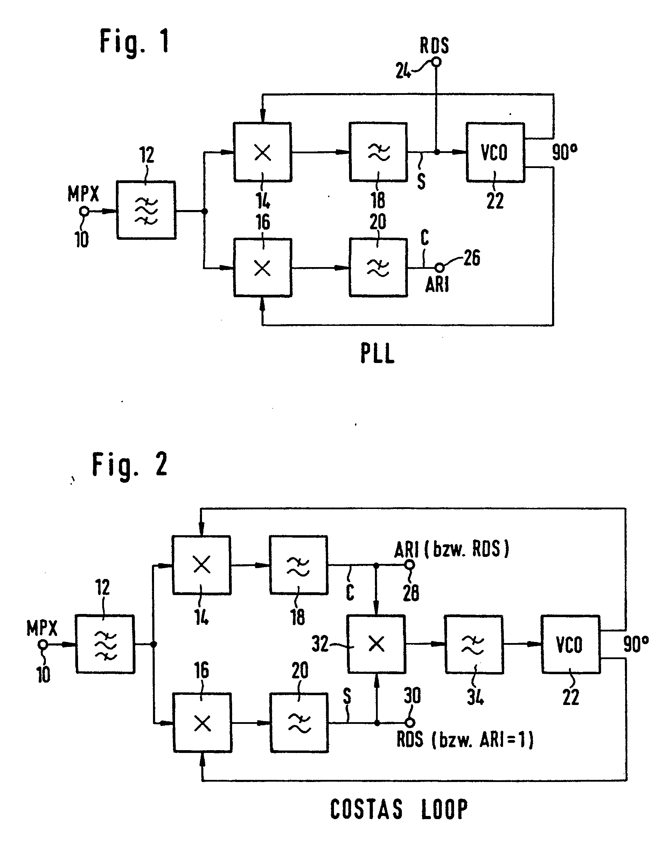

Zum besseren Verständnis der mit der Erfindung zusammenhängenden Problematik werden nachfolgend anhand von Fig. 1 und 2 zunächst ein PLL-Demodulator (Fig. 1) und ein Costas-Loop-Demodulator (Fig. 2) näher beschrieben, wobei darauf hinzuweisen ist, daß diese Schaltungen nicht geeignet sind, das mit der Erfindung erreichte Ergebnis zu erfüllen.

Dem PLL-Demodulator gemäß Fig. 1 wird über eine Eingangsklemme 10 ein an sich bekanntes MPX-Signal zugeführt, welches ein aufmoduliertes ARI-Signal und/oder ein aufmoduliertes RDS-Signal enthält. Durch einen Bandpaß 12 (57 kHz-Filter) wird der Frequenzbereich um 57 kHz herausgefiltert.

An den Bandpaß 12 schließen sich jeweils zwei Mischer 14 und 16 an, die von zwei in der Phase um 90° gegeneinander verschobene Signale eines spannungsgesteuerten Oszillators 22 angesteuert werden. Das Ausgangssignal des oberen Mischers 14 führt zu einem Tiefpaß 18, und das Ausgangssignal des unteren Mischers 16 wird einem unteren Tiefpaß 20 zugeführt.

Am Ausgang des oberen Tiefpasses 18 kann an der Ausgangsklemme 24 ein RDS-Signal abgegriffen werden, und am Ausgang des unteren Tiefpasses 20 steht an der Ausgangsklemme 26 ein ARI-Signal zur Verfügung.

Der soweit beschriebene PLL-Demodulator ist nur in der Lage, auf ein trägerbehaftetes Signal einzurasten. Daher ist es nur für den Fall ARI = 1 möglich, ein RDS-Signal zu erhalten, während die Schaltung bei ARI = 0 versagt.

In Fig. 2 ist als Costas-Loop-Schaltung ein Prinzip-Blockschaltbild dargestellt. Bekanntlich sind Costas-Loop-Schaltungen für die Demodulation von trägerlosen Signalen geeignet, und das Prinzip einer solchen Schaltung besteht darin, nach einer Mischung des Eingangssignales mit zwei um 90° gegeneinander phasenverschobenen Hilfssignalen, die gemischten Signale zu multiplizieren (in einem Costas-Loop-Mischer) und mit dem multiplikativ gewonnenen Ausgangssignal nach einer Tiefpaßfilterung einen spannungsgesteuerten Oszillator anzusteuern.

Neben den beiden Mischern 14 und 16 und den Tiefpässen 18 und 20 umfaßt daher die Costas-Loop-Schaltung gemäß Fig. 2 eine Mischstufe 32 (Costas-Loop-Mischer), welcher zur multiplikativen Verknüpfung die Sinus- und Cosinunskomponente, dabei handelt es sich um die Ausgangssignale der beiden Tiefpässe 18 und 20, zugeführt werden.Das Ausgangssignal der Mischstufe 32 gelangt über einen Tiefpaß 34 zu dem spannungsgesteuerten Oszillator 22.

Vergleichbar der PLL-Schaltung gemäß Fig. 1 entstehen auch bei der Costas-Loop-Schaltung in Fig. 2 wegen der um 90° gegeneinander phasenverschobenen Hilfssignale an den Ausgängen der Tiefpässe 18 und 20 also Ausgangssignale mit Sinus- und Cosinuskomponente, die als Steuersignale S und C für den Oszillator 22 weiterverarbeitet werden.

Bei dieser Costas-Loop-Schaltung läßt sich an der Ausgangsklemme 28 ein ARI-Signal abgreifen, und an der gleichen Ausgangsklemme 28 kann ein RDS-Signal entnommen werden, wenn die Beziehung ARI = 0 gilt. An der unteren Ausgangsklemme 30 tritt das RDS-Signal bei ARI = 1 auf. Das bedeutet mit anderen Worten, daß das RDS-Signal einmal an der Ausgangsklemme 28 und einmal an der Ausgangsklemme 30 erscheint, abhängig davon, ob ARI = 1 oder ARI = 0 ist. Dieses unterschiedliche Vorhandensein des RDS-Signales an unterschiedlichen Ausgangsklemmen ist darauf zurückzuführen, daß aufgrund der vorgegebenen Normung und der Realisierung der unterdrückte RDS-Träger um 90° in der Phase gegenüber dem ARI-Träger verschoben ist. Die soweit beschriebenen beiden Schaltungen gemäß Fig. 1 und 2 sind daher nicht geeignet, ein RDS-Signal immer an der gleichen Ausgangsklemme abnehmen zu können.

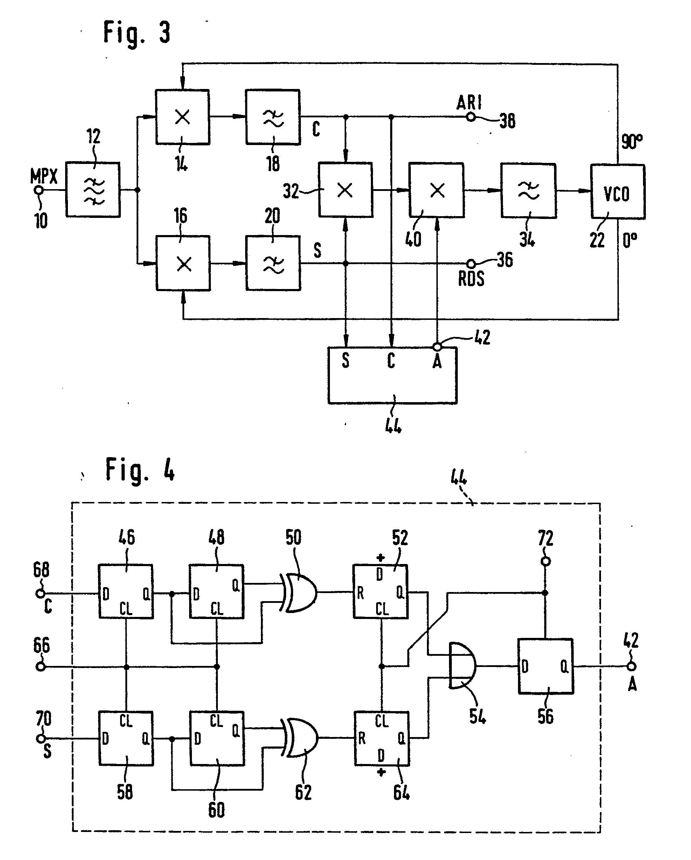

In Fig. 3 ist als Ausführungsbeispiel der Erfindung ein Demodulator dargestellt, bei welchem demgegenüber gewährleistet ist, daß das RDS-Signal unabhängig von der Anwesenheit des ARI-Trägers immer an einem bestimmten Ausgang zur Verfügung steht.

Der neue Demodulator ist grundsätzlich als Costas-Loop-Schaltung aufgebaut. An den Bandpaß 12 schließen sich wieder die beiden Mischer 14 und 16 an, die zu den beiden Tiefpässen 18 und 20 führen. Außerdem werden die Mischer 14 und 16 von dem spannungsgesteuerten Oszillator 22 mit den um 90° gegeneinander phasenverschobenen Hilfssignalen angesteuert.

An den Ausgängen der Tiefpässe 18 und 20 sind die Cosinus-und Sinuskomponente C und S vorhanden, die den Mischer 32 (Costas-Mischer) speisen. Außerdem ist eine ARI-Erkennungsschaltung 44 vorgesehen, der die Sinus- und Cosinuskomponenten der Ausgangssignale zugeführt werden. Der ARI-Ausgang 42 der Ari-Erkennungsschaltung 44 ist mit einem weiteren Mischer 40 verbunden, der von dem anderen Mischer 32 gespeist wird, und dessen Ausgangssignal dem spannungsgesteuerten Oszillator 22 über den Tiefpaß 34 zugeführt wird.

Mit Hilfe des von dem ARI-Ausgang 42 beeinflußten Mischers 40 wird das Steuersignal für den spannungsgesteuerten Oszillator 22 in der Weise beeinflußt, daß an der Ausgangsklemme 36 stets ein RDS-Signal und an der Ausgangsklemme 38 ein ARI-Signal entnommen werden kann. Das RDS-Signal ist dabei immer an der Ausgangsklemme 36 vorhanden, und zwar unabhängig von der Anwesenheit eines ARI-Trägers.

Der Demodulator gemäß Fig. 3 läßt sich mit seiner Loop so einstellen, daß das RDS-Signal bei A = 0 (ARI-Pegel gleich 0) und bei ARI = 0 am Ausgang des unteren Tiefpasses 20 bei S bzw. an der Ausgangsklemme 36 erscheint, was sich durch eine Grunddimensionierung im Sinne einer einmaligen Vorgabe erreichen läßt (wie dies in der eingangs genannten eigenen älteren Patentanmeldung EP-A-025 4061 schon beschrieben ist). Die Costas-Loop-Schaltung rastet dann immer so ein, daß die Signalextremwerte bei S und die Signal-Nulldurchgänge bei C (Ausgang des Tiefpasses 18) erscheinen.

Unter den Voraussetzungen ARI = 1 und A = 0 würde das ARI-Signal normalerweise bei S erscheinen, weil die Regelschleife dann auf das stärkere ARI-Signal einrasten würde, und das RDS-Signal würde bei C erscheinen.

Bei A = 1 und bei der gemäß der Erfindung damit verbundenen Invertierung der Costas-Loop-Steuergröße wird in Fig. 3 eine 90°-Drehung des stabilen Zustandes erreicht. Als Folge davon tritt das RDS-Signal immer bei S an der Ausgangsklemme 36 auf, sobald ARI richtig erkannt wird. Für den Fall möglicher kurzzeitiger Fehlerkennungen könnte höchstens ein schwaches Phasenjitter eintreten.

Ein wichtiger Aspekt ist also die ARI-Erkennung mit Hilfe der ARI-Erkennungsschaltung 44, um die Steuergröße der Costas-Loop für den spannungsgesteuerten Oszillator 22 invertieren zu können. Als ARI-Erkennung kann dabei beispielsweise die Information dienen, daß innerhalb der letzten RDS-Periode eines der beiden Signale C oder S frei von Vorzeichenwechseln war (dann gilt ARI = 1). Für den Fall, daß die Signalanteile C und S binär vorliegen, genügt eine Flankenerkennung. Eventuell mögliche kurzzeitige Fehler der Erkennung werden von dem Tiefpaßfilter 34 eliminiert, d.h. die Phasensteuerung reagiert auf den Mittelwert des ARI-Pegels A, wobei A = 1 ist, wenn ARI erkannt wird.

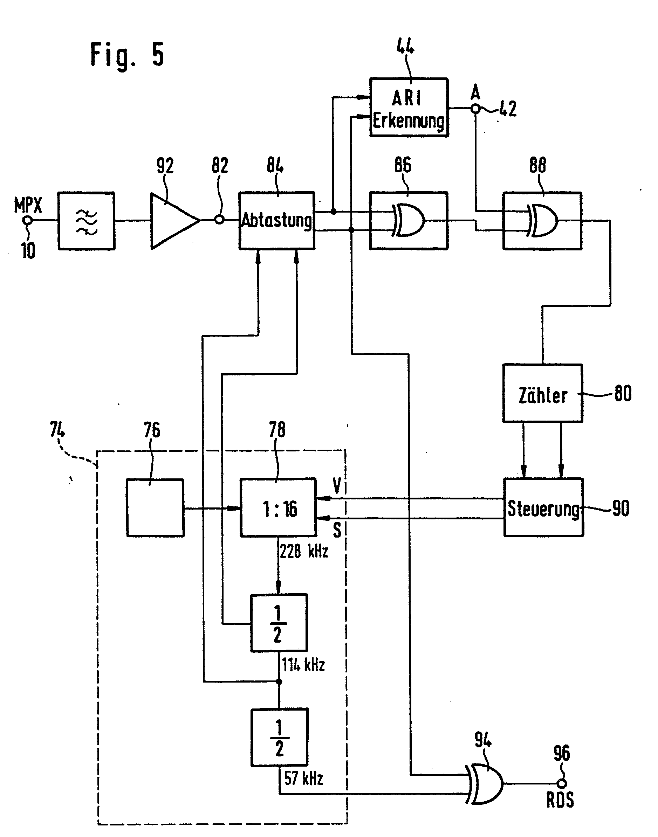

Eine besonders vorteilhafte schnelle ARI-Erkennungsschaltung 44 ist in Fig. 4 dargestellt. Die Cosinuskomponente C des Signals am Ausgang des Tiefpasses 18 wird einer ersten Eingangsklemme 68 zugeführt, und die Sinuskomponete S gelangt zu einer zweiten Eingangsklemme 70. Die ARI-Erkennungsschaltung 44 gemäß Fig. 4 besitzt ferner eine weitere dritte Eingangsklemme 66, die mit einem Signal der Taktfrequenz von 19 kHz beaufschlagt ist (1/3 der Trägerfrequenz von 57 kHz).

An die Eingangsklemme 68 schließen sich zwei D-Flip-Flop 46 und 48 sowie ein EX-OR-Glied 50 an, und in vergleichbarer Weise führt die andere Eingangsklemme 70 zu zwei D-Flip-Flop 58, 60 mit einem nachgeschalteten EX-OR-Glied 62. Die beiden EX-OR-Glieder 50, 62 führen jeweils zu einem Flip-Flop 52 bzw. 64, die mit einem gemeinsamen ODER-Glied 54 verbunden sind. Der Ausgang des ODER-Gliedes 54 führt zu einem weiteren Flip-Flop 56, dem über eine Eingangsklemme 72 eine RDS-Frequenz von 1,1875 kHz zugeführt wird, und dessen Ausgang (Q) den ARI-Ausgang 42 der ARI-Erkennungsschaltung 44 bildet.

Die beiden Flip-Flop 46, 48 bzw. 58, 60 bilden jeweils ein Schieberegister, so daß die Eingangssignale durchgeschoben werden. Mittels der beiden EX-OR-Glieder 50 und 62 erfolgt praktisch eine Abfrage, ob die jeweils beiden Eingänge der EX-OR-Glieder 50, 62 gleich oder ungleich sind. Bei Gleichheit liegt der Ausgang des betreffenden EX-OR-Gliedes 50, 62 auf "0" und im anderen Fall (bei Ungleichheit der Eingänge) auf "1"; dann werden die folgenden Flip-Flop 52, 64 zurückgesetzt. Das Ausgangs-Flip-Flop 56 wird über die Eingangsklemme 72 mit der RDS-Frequenz (1,1875 kHz) getaktet, und die beiden Flip-Flop 52, 64 werden mit den Flanken der RDS-Frequenzsignale gesetzt.

Wenn kein ARI vorliegt, besitzen die Signale C und S laufend Nulldurchgänge bzw. Flanken (bei binären Signalen), und innerhalb einer RDS-Periode werden die beiden Flip-Flop 52 und 64 zurückgesetzt. Als Folge davon ist A = 0 am ARI-Ausgang 42.

Wenn demgegenüber ARI vorhanden ist, besitzen die Signale C oder S keine Nulldurchgänge, und dies bedeutet, daß Flip-Flop 52 oder Flip-Flop 64 gesetzt bleibt. Beim folgenden Takt wird dann an dem ARI-Ausgang 42 A = 1. Jetzt wird also in Fig. 3 die Steuergröße der Costas-Loop für den spannungsgesteuerten Oszillator 22 invertiert.

In vorteilhafter Weise können Teile des Demodulators oder auch der gesamte Demodulator mit digitalen Bauteilen so aufgebaut werden, daß die Signale binär sein können, wie das bei der schnellen ARI-Erkennungsschaltung 44 gemäß Fig. 2 schon dargestellt ist.

Ein Prinzip-Blockschaltbild eines neuen Demodulators für binäre Signale ist in Fig. 5 gezeigt. Der Oszillator ist hier als digitaler "VCO" (DCO) 74 ausgebildet, der in an sich bekannter Weise aus einem hochfrequenten Festoszillator 76 mit einem nachgeschalteten steuerbaren Frequenzteiler 78 bestehen kann. Der Tiefpaß kann gegebenenfalls entfallen oder durch einen Integrator-Zähler 80 ersetzt werden, dessen MSB ("Most Significand Bit") die Richtung der Frequenzvariation und dessen Überlauf und/oder Unterlauf ("Carry Condition") die Häufigkeit der Frequenzvariation angibt. Diese Häufigkeit kann auch konstant gewählt werden.

Am Ausgang 82 eines Komparators 92 liegen die binären Signale vor. Es folgt eine Abtastschaltung 84, an die sich ein Costas-Mischer 86 sowie die ARI-Erkennungsschaltung 44 anschließen. Die Abtastung wird mit zwei 114 kHz-Folgen durchgeführt. Der Costas-Mischer für die binären Signale ist als ein EX-OR-Glied 86 ausgebildet.

Die binäre Steuergröße der Costas-Loop kann den Up/Down-Eingang des Integrator-Zählers 80 speisen, und zwar unter Zwischenschaltung eines EX-OR-Gliedes 88, dessen anderer Eingang von der ARI-Erkennungsschaltung 44 gesteuert wird, und der gegebenenfalls eine Invertierung bewirkt. Der Costas-Mischer 86 sorgt für eine Synchronisation der Eingangsflanken auf eine der beiden 114 kHz-Folgen, während der Inverter 88 ein Umschalten auf die andere 114 kHzFolge bewirkt.

An den Integrator-Zähler 80 schließt sich für die Aufbereitung und die Steuerung des Frequenzteilers 78 eine Steuerschaltung 90 an. Ein "Carry" bewirkt dort einen Impuls der Dauer 1/228 kHz, wenn zuvor der Integrator-Zähler 80 die Mitte passiert hat (Set Ready FF). Ready FF wird durch den Impuls V zurückgesetzt.

Der steuerbare Frequenzteiler 78 wird von einem Festoszillator 76 der Frequenz 3,648 MHz angesteuert. Zunächst erfolgt eine Teilung durch "16", so daß 228 kHz entstehen, aus denen die beiden 114 kHz-Folgen als orthogonale Clockfolgen abgeleitet werden.

Bei hinreichend gefilterten Eingangssignalen kann - wie das Schaltbild in Fig. 5 zeigt - auf Tiefpässe hinter den Eingangsmischern verzichtet werden, wenn das Eingangssignal selbst binär ist und gemäß Fig. 5 mit zwei orthogonalen Clockfolgen abgetastet wird. In gewünschter Weise steht am Ausgang 96 eines EX-OR-Gliedes 94 (welches die Signale mit 57 kHz heruntermischt) das RDS-Signal zur weiteren Aufbereitung mittels einer RDS-Kennung zur Verfügung.

**Ansprüche**

1. Digitaler Demodulator zur Demodulation eines Trägers (MPX, 10), der aus einem ersten, zusammen mit dem Träger übertragenen ARI-Signal und/oder aus einem zweiten, mit unterdrücktem Träger übertragenen RDS-Signal besteht, wobei der Träger des ARI-Signals um 90° gegenüber dem frequenzgleichen Träger des RDS-Signals phasenverschoben ist,

mit Mischern (14, 16), denen das Eingangssignal und je ein Hilfssignal aus einem spannungsgesteuerten Oszillator (VCO, 22) zugeführt sind, wobei das eine Hilfssignal um 90° gegenüber dem zweiten Hilfssignal phasenverschoben ist,

und mit an die Mischer (14, 16) angeschlossenen Tiefpässe (18, 20), wobei an dem Ausgang des einen Tiefpasses (18) eine Sinuskomponente, am Ausgang des anderen Tiefpasses (20) eine Kosinuskomponente der Trägermodulation abnehmbar ist, und diese Komponenten zu einem Steuersignal für die Ansteuerung des spannungsgesteuerten Oszillators (C22) über gegebenenfalls einen weiteren Tiefpaß (34) herangezogen sind,
dadurch gekennzeichnet,
daß eine schnelle ARI-Erkennungsschaltung (44) vorgesehen ist, an deren Ausgang bei Vorhandensein eines ARI-Signals ein dieses repräsentierender Signalpegel (A) abnehmbar ist, und daß das Steuersignal für die Ansteuerung des Oszillators (22) in Abhängigkeit von dem Signalpegel (A) invertiert wird.

2. Demodulator nach Anspruch 1, dadurch gekennzeichnet, daß die Sinus- und Cosinuskomponenten (S, C) des ersten und zweiten amplitudenmodulierten Signals am Ausgang der Tiefpässe (18, 20) einem Costas-Mischer (32) sowie der ARI-Erkennungsschaltung (44) zugeführt sind.

3. Demodulator nach Anspruch 2, dadurch gekennzeichnet, daß das Ausgangssignal des Costas-Mischers (32) einem weiteren Mischer (40) zugeführt ist, der von dem ARI-Ausgang (42) der ARI-Erkennungsschaltung (44) angesteuert ist.

4. Demodulator nach Anspruch 3, dadurch gekennzeichnet, daß der weitere Mischer (40) den Oszillator (22) über einen Tiefpaß (34) ansteuert.

5. Demodulator nach einem der vorhergehenden Ansprüche 1 - 4, dadurch gekennzeichnet, daß durch die ARI-Erkennungsschaltung (44) bei Vorhandensein eines ARI-Signals (A = 1) eine Invertierung des Steuersignals für den Oszillator (22) zwischen dem Costas-Mischer (32) und dem Oszillator (22) erfolgt.

6. Demodulator nach einem der vorhergehenden Ansprüche 1 - 5, dadurch gekennzeichnet, daß der ARI-Erkennungsschaltung (44) neben den Sinus- und Cosinuskomponenten (S, C) des ersten und zweiten amplitudenmodulierten Signals ein Taktsignal mit einer Taktfrequenz zugeführt (66) ist.

7. Demodulator nach Anspruch 6, dadurch gekennzeichnet, daß die Taktfrequenz ein ganzzahliger Teil der Frequenz des ersten bzw. zweiten Trägers der amplitudenmodulierten Signale ist.

8. Demodulator nach einem der vorhergehenden Ansprüche 2 - 7, dadurch gekennzeichnet, daß die Cosinuskomponente (C) einer ersten Eingangsklemme (68) der ARI-Erkennungsschaltung (44) zugeführt ist, und daß sich an die erste Eingangsklemme (68) zwei Flip-Flop (46, 48), ein EX-OR-Glied (50) mit einem nachgeschalteten Flip-Flop (52) anschließen, das über ein gemeinsames ODER-Glied (54) zu einem Flip-Flop (56) führt, welches mit dem ARI-Ausgang (42) verbunden ist.

9. Demodulator nach einem der vorhergehenden Ansprüche 2 - 8, dadurch gekennzeichnet, daß die Sinuskomponente (S) einer zweiten Eingangsklemme (70) der ARI-Erkennungsschaltung (44) zugeführt ist, und daß sich an die zweite Eingangsklemme (70) zwei weitere Flip-Flop (58, 60), ein weiteres EX-OR-Glied (62) mit einem nachgeschalteten Flip-Flop (64) anschließen, welches über das gemeinsame ODER-Glied (54) zu dem mit dem ARI-Ausgang (42) verbundenen Flip-Flop (56) führt.

**Claims**

1. Digital demodulator for demodulating a carrier (MPX, 10), which consists of a first ARI signal transmitted together with the carrier and/or of a second RDS signal transmitted with suppressed carrier, in which arrangement the carrier of the ARI signal is phase-shifted by 90° compared with the carrier of the RDS signal of the same frequency, comprising mixers (14, 16) which are supplied with the input signal and one auxiliary signal each from a voltage-controlled oscillator (VCO, 22), in which arrangement one auxiliary signal is phase-shifted by 90° compared with the second auxiliary signal, and comprising low-pass filters (18, 20) connected to the mixers (14, 16), in which arrangement a sinusoidal component can be picked up at the output of one low-pass filter (18) and a cosinusoidal component of the carrier modulation can be picked up at the output of the other low-pass filter (20) and these components are utilised to form a control signal for driving the voltage-controlled oscillator (C22) via, if necessary, a further low-pass filter (34), characterised in that a fast ARI detection circuit (44) is provided, at the output of which, when an ARI signal is present, a signal level (A) representing it can be picked up, and in that the control signal for driving the oscillator (22) is inverted in dependence on the signal level (A).

2. Demodulator according to Claim 1, characterised in that the sinusoidal and cosinusoidal components (S, C) of the first and second amplitude-modulated signals at the output of the low-pass filters (18, 20) are supplied to a Costas-type mixer (32) and to the ARI detection circuit (44).

3. Demodulator according to Claim 2 , characterised in that the output signal of the Costas-type mixer (32) is supplied to a further mixer (40) which is driven by the ARI output (42) of the ARI detection circuit (44).

4. Demodulator according to Claim 3 , characterised in that the further mixer (40) drives the oscillator (22) via a low-pass filter (34).

5. Demodulator according to one of the preceding Claims 1-4, characterised in that, when an ARI signal is present (A = 1) an inversion of the control signal for the oscillator (22) is effected between the Costas-type mixer (32) and the oscillator (22) by the ARI detection circuit (44).

6. Demodulator according to one of the preceding Claims 1-5, characterised in that, in addition to the sinusoidal and cosinusoidal components (S, C) of the first and second amplitude-modulated signals, the ARI detection circuit (44) is supplied with a clock signal having a clock frequency (66).

7. Demodulator according to Claim 6, characterised in that the clock frequency is an integral proportion of the frequency of the first and second carrier, respectively, of the amplitude-modulated signals.

8. Demodulator according to one of the preceding Claims 2-7, characterised in that the cosinusoidal component (C) is supplied to a first input terminal (68) of the ARI detection circuit (44), and in that the first input terminal (68) is followed by two flip-flops (46, 48) and an EXOR gate (50) with a subsequent flip-flop (52) which leads via a common OR gate (54) to a flip-flop (56) which is connected to the ARI output (42).

9. Demodulator according to one of the preceding Claims 2-8, characterised in that the sinusoidal component (5) is supplied to a second input terminal (70) of the ARI detection circuit (44), and in that the second input terminal (70) is followed by two further flip-flops (58, 60) a further EXOR gate (62) with a subsequent flip-flop (64) which leads via the common OR gate (54) to the flip-flop (56) connected to the ARI output (42).

**Revendications**

1. Démodulateur numérique pour démoduler une porteuse (MPX, 10) qui est constitué d'un premier signal ARI transmis en même temps que la porteuse, et/ou d'un second signal RDS transmis avec porteuse supprimée, la porteuse du signal ARI étant décalée en phases de 90° par rapport à la porteuse de même fréquence du signal RDS, avec des mixeurs (14, 16) auxquels sont appliqués le signal d'entrée et respectivement un signal auxiliaire en provenance d'un oscillateur (VCO, 22) commandé en tension, l'un de ces signaux auxiliaires étant décalé de 90° par rapport au second signal auxiliaire, et avec des filtres passe-bas (18, 20) raccordés aux mixeurs (14, 16), une composante sinus pouvant être prélevée à la sortie de l'un (18) des filtres passe-bas, tandis qu'à la sortie de l'autre filtre passe-bas (20) peut être prélevée une composante cosinus de la modulation de porteuse, et il est fait appel à ces composantes pour constituer un signal de commande afin de commander l'oscillateur (C22) commandé en tension par l'intermédiaire éventuellement d'un autre filtre passe-bas (34), démodulateur numérique caractérisé en ce qu'il est prévu un circuit d'identification ARI rapide (44) à la sortie duquel, lors de la présence d'un signal ARI, peut être prélevé un niveau de signal (A) représentant celui-ci, et en ce que le signal pour la commande de l'oscillateur est inversé en fonction du niveau de signal (A).

2. Démodulateur selon la revendication 1, caractérisé en ce que les composantes sinus et cosinus (S, C) du premier et du second signal modulé en amplitude à la sortie des filtres passe-bas (18, 20) sont appliquées à un mixeur de Costas (32) ainsi qu'au circuit d'identification ARI (44).

3. Démodulateur selon la revendication 2, caractérisé en ce que le signal de sortie du mixeur de Costas (32) est appliqué à un autre mixeur (40) qui est commandé par la sortie ARI (42) du circuit d'identification ARI (44).

4. Démodulateur selon la revendication 3, caractérisé en ce que l'autre mixeur (40) commande l'oscillateur (22) par l'intermédiaire d'un filtre passe-bas (34).

5. Démodulateur selon une des précédentes revendications 1 à 4, caractérisé en ce que, grâce au circuit d'identification ARI (44), lors de la présence d'un signal ARI (A = 1), une inversion du signal de commande pour l'oscillateur (22) s'effectue entre le mixeur de Costas (32) et l'oscillateur (22).

6. Démodulateur selon une des précédentes revendications 1 à 5, caractérisé en ce qu'au circuit d'identification ARI (44) est appliqué, à côté des composantes sinus et cosinus (S, C) du premier et du second signal modulé en amplitude, un signal de synchronisation avec une fréquence de synchronisation.

7. Démodulateur selon la revendication 6, caractérisé en ce que la fréquence de synchronisation est une partie entière de la fréquence de la première ou de la seconde porteuse des signaux modulés en amplitude.

8. Démodulateur selon une des précédentes revendications 2 à 7, caractérisé en ce que la composante cosinus (C) est appliquée à une première borne d'entrée (68) du circuit d'identification ARI (44), et en ce que, à cette première borne d'entrée (68), se raccordent deux bascules (46, 48), un organe EX-OU (50) avec une bascule (52) branchée à la suite, qui, par l'intermédiaire d'un organe commun OU (54) aboutit à une bascule (56) qui est reliée à la sortie ARI (42).

9. Démodulateur selon une des précédentes revendications 2 à 8, caractérisé en ce que la composante sinus (5) est appliquée à une seconde borne d'entrée (70) du circuit d'identification ARI (44), et en ce qu'à la deuxième borne d'entrée (70) se raccordent deux autres bascules (58, 60), un autre organe EX-OU (62) avec une bascule (64) branchée à la suite, qui par l'intermédiaire de l'organe OU commun (54) aboutit à la bascule (56) reliée à la sortie ARI (42).

## Fig. 1

RDS

24

MPX

10

12

14

16

18

20

S

C

ARI

26

VCO

22

90°

PLL

## Fig. 2

MPX

10

12

14

16

18

20

32

34

S

C

ARI ( bzw. RDS )

28

RDS ( bzw. ARI = 1 )

30

VCO

22

90°

COSTAS LOOP

# Fig. 3

# Fig. 4

# Fig. 5